# EUROPEAN PATENT APPLICATION

(11) **EP 1 137 076 A1**
(43) Date of publication of application: **26.09.2001**
(21) Application number: 00915368.5
(22) Date of filing: 06.04.2000
(51) Int. Cl.: H01L 31/042, H01L 31/0224

(54) **MATERIAL FOR SOLAR CELL INTERCONNECTOR AND METHOD FOR PREPARATION THEREOF**

(30) Priority: 20.08.1999 JP 27289999
(71) Applicant: Tanaka Kikinzoku Kogyo K.K., Tokyo 103-0025 (JP)
(72) Inventor: SHIMA, Kunihiro, c/o Tanaka Kikinzoku Kogyo KK, Hiratsuka-shi, Kanagawa 254-0076 (JP)
(74) Representative: Klunker . Schmitt-Nilson . Hirsch
(86) International application number: JP0002222
(87) International publication number: WO0115238

(57) **Abstract**

The invention provides a material for an interconnector of a solar cell comprising MgO or both MgO and NiO dispersed in Ag. The especially preferable ratio between Ag and MgO or among Ag, MgO and NiO is 0.03 to 3.3wt% of MgO with the balance being Ag, or 0.01 to 1.7wt% of MgO and 0.02 to 1.3wt% of NiO with the balance being Ag, respectively. The material for an interconnector of a solar cell according to the present invention can be produced by subjecting a base material comprising an Ag-Mg composition or an Ag-Mg-Ni composition to melting, casting and then rolling; during processing the material to an intended thickness, subjecting the material to internal oxidation treatment in an atmosphere of oxygen at 650-850°C for 20-80 hours at 3-10 atm; and rolling the resultant material until the intended thickness is achieved. The invention has such a special, remarkable working effect that the material has high resistance against thermal energy (i.e., less susceptibility to heat) and high mechanical strength which are satisfactory as products, compared with the conventional known materials for interconnectors of solar cells.

## Description

### Technical Field

The present invention relates to a material for an interconnector of a solar cell employed in artificial satellites. The present invention provides a material having good thermal stability, that is, less susceptibility to softening which may be caused by heat, and high mechanical strength satisfactory as an interconnector.

### Background Art

Heretofore, there are known a variety of alloy materials containing Ag as the main component for interconnectors of solar cells. When exposed to severe environments beyond our expectation in outer space, the material may be largely affected by thermal energy generated in the environments, so that the alloy materials may be first softened and eventually reduced in mechanical strength, leading to loss of function as interconnectors.

These disadvantages may lead to the loss of functions of the solar cells. Therefore, it would become impossible to achieve the intended purposes of the solar cells. For these reasons, there is an urgent necessity for improving the materials for interconnectors.

As the conventional materials for interconnectors of solar cells, those materials have been employed, for example, which comprise Ca, In, Be and so on in Ag. Several specific examples of the conventional interconnectors are disclosed in Japanese Examined Patent Application Publication No. 7-83132 in which the interconnectors are made of an Ag alloy containing 10 to 1000 ppm of Ca; Japanese Patent No. 2727729, in which the interconnectors are made of an alloy containing 10 to 750 ppm of one or more elements selected from rare earth elements (e.g., La, Nb, Pr, etc.) and In with the balance being Ag; and Japanese Patent No. 2727730, in which the interconnectors are made of an Ag alloy foil containing 10 to 1000 ppm of Ca and 10 to 750 ppm of one or more elements selected from In, Be and rare earth elements with the balance being Ag.

However, when thermally affected in the severe environments as mentioned above, these conventional materials are softened and remarkably decreased in mechanical strength, and hence may exhibit unsatisfactory properties. Therefore, it has been strongly demanded that improved materials come on the market. Moreover, when exposed to thermal cycling for a prolonged period of time, Ag alloys may cause changes in quality so that it is difficult to maintain the intended performance of the alloys, because Ag itself is thermally unstable, and the alloys may undergo various changes even in oxidized forms, depending on the types of the constituent alloy elements.

### Disclosure of Invention

The object of the present invention is to provide a material for an interconnector of a solar cell, which is less susceptible to softening and is able to maintain satisfactory mechanical strength even under severe environments beyond our expectations in outer space.

The present inventor has made extensive studies for the purpose of improving the above-mentioned problems. The inventor has focused attention on the unexpected high thermal stability of Mg and Ni metal oxides. As a result, the inventor has found that it is possible to produce materials for interconnectors of solar cells which have flexibility, good deformational processibility, less susceptibility to softening which may be caused by heat, and high mechanical strength, by incorporating Mg or both Mg and Ni into an alloy base Ag at a specific compositional ratio.

That is, the invention according to claim 1 provides a material for an interconnector of a solar cell comprising MgO or both MgO and NiO dispersed in Ag.

As recited in claim 1, the present invention is characterized in that Ag is employed as the base material and an oxide of Mg or Ni is dispersed therein to increase the thermal stability of the resulting interconnector. With respect to the elements employed for the formation of the alloy, the present invention is distinct from the prior art inventions mentioned above. In addition, according to the present invention, the oxide of Mg or Ni is fully internally oxidized and then dispersed in Ag. In contrast, in the prior art inventions, there is found no teaching concerning such dispersion or no description concerning the production of oxides with high thermal stability.

The ratio between Ag and MgO or among Ag, MgO and NiO may be 0.03 to 3.3wt% of MgO with the balance being Ag, or 0.01 to 1.7wt% of MgO and 0.02 to 1.3wt% of NiO with the balance being Ag, respectively, as recited in claim 2.

As described above, in the present invention, the following alloy composition is employed: when only MgO is dispersed in Ag, the content of MgO is 0.03 to 3.3wt%; and when both MgO and NiO are dispersed in Ag, the contents of MgO and NiO are 0.01 to 1.7wt% and 0.02 to 1.3wt%, respectively. This is because, if the contents of MgO and NiO are less than 0.01wt% and 0.02wt%, respectively, then improvement in mechanical strength cannot be achieved. If the contents exceed 1.7wt% and 1.3wt%, respectively, then the resultant material becomes too hard so that it is difficult to process the material.

The method for producing a material for an interconnector of a solar cell according to the present invention comprises: subjecting a base material comprising an Ag-Mg composition or an Ag-Mg-Ni composition to melting, casting and then rolling; during processing the material to an intended thickness, subjecting the material to internal oxidation treatment in an atmosphere of oxygen at a temperature of 650 to 850°C for a time period of 20 to 80 hours at a pressure of 3 to 10 atm; and rolling the resultant material until the intended thickness is achieved.

In the process of the internal oxidation treatment of the Ag-Mg or Ag-Mg-Ni composition (i.e., the base material) which is performed during processing the material, oxygen penetrates into the material under a high temperature/pressure condition to oxidize the internal Mg and Ni successively. In this process, Ag itself is not oxidized but serves to make the oxygen pass through the material and transmit it to the center portion of the material.

The condition employed for the internal oxidation is an atmosphere of oxygen at a temperature of 650 to 850°C for a time period of 20 to 80 hours at a pressure of 3 to 10 atm. This is because, if the temperature is lower than 650°C, then the internal oxidation cannot proceed satisfactorily; whereas if it exceeds 850°C, then the resulting oxide grows too large so that the desired properties of the resulting interconnector cannot be achieved. If the time for oxidation is shorter than 20 hours, then the internal oxidation cannot proceed satisfactorily; whereas if it exceeds 80 hours, a greater effect cannot be achieved and the time of working is prolonged, resulting in poor processibility. With respect to the pressure, if it is less than 3 atm, then the internal oxidation cannot proceed satisfactorily, whereas if it is higher than 10 atm, a larger scale apparatus is required, leading to the difficulty from the viewpoint of facility.

In the production of the material for an interconnector of a solar cell by the method of claim 3, it is preferable that the Ag-Mg composition or Ag-Mg-Ni composition as the base material have a composition of 0.02 to 2.0wt% of Mg with the balance being Ag or 0.01 to 1.0wt% of Mg and 0.01 to 1.0wt% of Ni with the balance being Ag, respectively, as recited in claim 4.

By using the base material having the composition falling within the above ranges, it becomes possible to provide the contents of MgO and NiO falling within the ranges desirable for a material for an interconnector of a solar cell, namely, 0.03 to 3.3wt% of MgO; or 0.01 to 1.7wt% of MgO and 0.02 to 1.3wt% of NiO.

### Best Mode for Carrying Out the Invention

Hereinbelow, the present invention will be described in more detail by way of examples.

### EXAMPLE 1:

A composition containing 0.10wt% of Mg and 0.10wt% of Ni in Ag was melted and cast into an ingot. The ingot was rolled. Before the desired thickness was achieved, the ingot was subjected to internal oxidation treatment in an atmosphere of oxygen at 750°C for 50 hours at 5 atm. The resulting oxide was found to contain Ag, 0.13wt% of MgO and 0.17wt% of NiO. The oxide was additionally rolled to produce a tape with the target thickness of 25 µm and a width of 115 mm.

The examination of the properties of the tape material revealed that the tape had a processing ratio 98% and the following post-processing properties: tensile strength of 510 MPa, hardness of 95 Hv, elongation of 1.0%, Young's modulus of 3.45 x 10⁴ MPa and specific resistance of 2.40 x 10⁻⁸ Ωm.

The material was subjected to a thermal cycling to determine the post-thermal cycling properties. In the thermal cycling, the material was maintained at 300°C (which is a more severe condition than that experienced in outer space) for 30 min. and then immediately immersed in water of room temperature to cool the material. This procedure was performed for 100 cycles.

The determination of the post-thermal cycling properties of the material revealed that the material had the following properties: tensile strength of 510 MPa; hardness of 95 Hv; elongation of 2.0%; Young's modulus of 3.20 x 10⁴ MPa; and specific resistance of 2.20 x 10⁻⁸ Ωm.

These results demonstrate that the material for an interconnector of a solar cell according to the present invention can retain good mechanical properties without reduction in strength or flexibility even when exposed to a more severe thermal cycling than that experienced in outer space.

### EXAMPLES 2-4:

Ag-Mg-Ni or Ag-Mg base materials of different compositions were processed into tape-shaped materials for interconnectors of solar cells according to the same procedure as in Example 1, and the post-processing and post-thermal cycling properties of the materials were determined. The compositions and properties of the materials produced in the individual Examples are shown in Table 1.

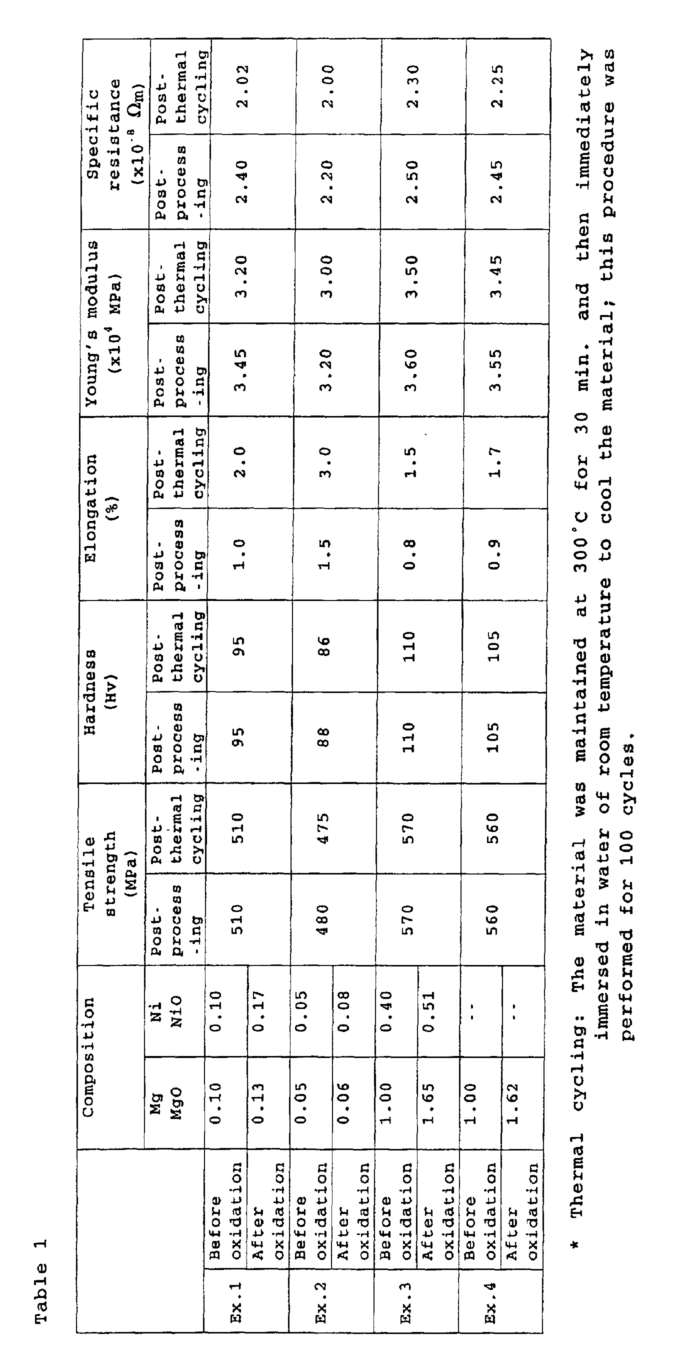

The results from Examples 2-4 also demonstrate that the material for an interconnector of a solar cell according to the present invention can retain good properties without reduction in mechanical or electrical properties even after thermal cycling.

### Industrial Applicability

As described above, the materials for interconnectors of solar cells according to the present invention have such a special, remarkable working effect that the materials have high resistance against thermal energy (i.e., less susceptibility to heat) and high mechanical strength which are satisfactory as products, compared with the conventional known materials for interconnectors of solar cells. This can be achieved by selecting a specific content of Mg and Ni as additive elements for Ag and dispersing the oxides of the additive elements in Ag by performing a specific oxidation treatment.

## Claims

1. A material for an interconnector of a solar cell comprising MgO or both MgO and NiO dispersed in Ag.

2. The material for an interconnector of a solar cell according to claim 1, wherein the ratio between Ag and MgO or among Ag, MgO and NiO is 0.03 to 3.3wt% of MgO with the balance being Ag or 0.01 to 1.7wt% of MgO, 0.02 to 1.3wt% of NiO with the balance being Ag, respectively.

3. A method for producing a material for an interconnector of a solar cell, comprising:
melting, casting and then rolling a base material comprising an Ag-Mg composition or an Ag-Mg-Ni composition;
during processing the material to an intended thickness, subjecting the material to internal oxidation treatment in an atmosphere of oxygen at a temperature of 650 to 850°C for a time period of 20 to 80 hours at a pressure of 3 to 10 atm; and
rolling the resultant material into the intended thickness.

4. The method for producing a material for an interconnector of a solar cell according to claim 3, wherein the Ag-Mg composition or the Ag-Mg-Ni composition as the base material has a composition of 0.02 to 2.0wt% of Mg with the balance being Ag or 0.01 to 1.0wt% of Mg and 0.01 to 1.0wt% of Ni with the balance being Ag, respectively.
